# DEMANDE DE BREVET EUROPEEN

(11) **EP 1 069 627 A1**
(43) Date de publication de la demande: **17.01.2001**
(21) Numéro de dépôt: 00402012.9
(22) Date de dépôt: 12.07.2000
(51) Int. Cl.: H01L 31/119, G01T 1/24, H01L 27/146

(54) **Capteur de particules à faible énergie**

(30) Priorité: 16.07.1999 FR 9909261
(71) Demandeur: CSEM Centre Suisse d'Electronique et de Microtechnique SA, 2007 Neuchâtel (CH)
(72) Inventeur: Weiss, Paul, 2000 Neuchatel (CH)
(74) Mandataire: Caron, Gérard

(57) **Abrégé**

Ce capteur de particules à faible énergie comprend des zones de collecte de courant (3) formant diode couvrant partiellement le substrat (1).

D'autres moyens définissent à côté des zones de collecte (3) des zones de détection (4) dans lesquelles la faible épaisseur de matière autorise la pénétration dans le substrat (1) de particules de faible énergie (particules α ou protons notamment).

Les courants engendrés par les particules par formation de paires électron-trou dans le substrat sont collectés par les régions de diode et envoyés dans un circuit d'exploitation.

Application notamment aux capteurs des détecteurs des produits résultant des collisions provoquées dans les machines de recherche en physique des particules.

## Description

La présente invention est relative à un capteur de particules du type utilisé notamment dans les détecteurs des installations de recherche telles que les accélérateurs, collisionneurs et autres, utilisées dans le domaine de la physique des particules. Un tel capteur est destiné en particulier à localiser avec précision le point de passage et d'interaction des particules générées au cours d'expériences effectuées dans ces appareils.

Un capteur de ce type est décrit dans un article de P. Weiss et al., présenté à l'occasion de la 7ième Conférence internationale sur les actuateurs et détecteurs à l'état solide, sous le titre "Wafer-scale Technology For Double-sided Silicon Microstrip Particle Detectors".

Ce détecteur connu est conçu essentiellement pour analyser les particules à haute énergie, mais du fait qu'il est optimisé pour des particules ayant une très longue portée, il est mal adapté à la détection de particules ayant une faible énergie comme les particules α ou les protons.

Par ailleurs, par JP 56 060 067 on connaît un détecteur de radiation comprenant un substrat semi-conducteur dans lequel sont ménagées des diodes MIS. L'une des faces du substrat est recouverte d'une couche isolante sur laquelle sont déposées des régions métalliques. A la face opposée du substrat, on prévoit des régions métalliques qui sont en coïncidence avec les régions métalliques.

Ainsi, chaque diode MIS comprend une région métallique, une couche sous-jacente isolante, la partie du substrat située sous la région métallique et enfin, à l'autre face du substrat la région métallique coïncidente. La structure de ces diodes est différente de celle de diodes de jonction dont il s'agit dans les capteurs du type visé par la présente invention.

Par ailleurs, les diodes MIS sont séparées les unes des autres par des zones isolantes sur lesquelles sont prévus des conducteurs destinés à connecter les diodes MIS aux bords de la matrice du capteur.

Dans ce capteur connu, du rayonnement ne peut être détecté que par les parties du capteur dans lesquelles se situent les diodes MIS. Cependant, ces parties ont une épaisseur trop importante pour permettre la détection d'un rayonnement de faible énergie. Ceci s'applique à fortiori aux parties du substrat dans lesquelles se situent les zones isolantes et les conducteurs de connexion de la matrice.

L'invention a pour but de créer un capteur de particules permettant la capture de particules de faible énergie.

Elle a donc pour objet un capteur de particules présentant les caractéristiques de la revendication 1.

Grâce à ces caractéristiques, le capteur présente des zones distinctes spécifiquement dédicacées aux collectes du courant d'une part et à la détection des particules d'autre part, ce qui permet de conférer aux zones de détection une épaisseur réduite au strict minimum, n'entravant pas le passage des particules dans le substrat.

D'autres particularités avantageuses de l'invention sont définies dans les sous-revendications.

D'autres caractéristiques et avantages de l'invention apparaîtront au cours de la description qui va suivre, donnée uniquement à titre d'exemple et faite en se référant aux dessins annexés sur lesquels:
- la figure 1 montre un schéma électrique équivalent d'un capteur de particules selon l'invention;
- la figure 2 en est une vue en perspective partielle;
- la figure 3 est une vue schématique partielle en plan du capteur;
- la figure 4 montre une variante du capteur selon l'invention; et
- la figure 5 illustre, par des vues schématiques en coupe désignées par a) à k), un procédé de fabrication d'un capteur de particules selon une variante légèrement différente de l'invention, par rapport à la figure 2.

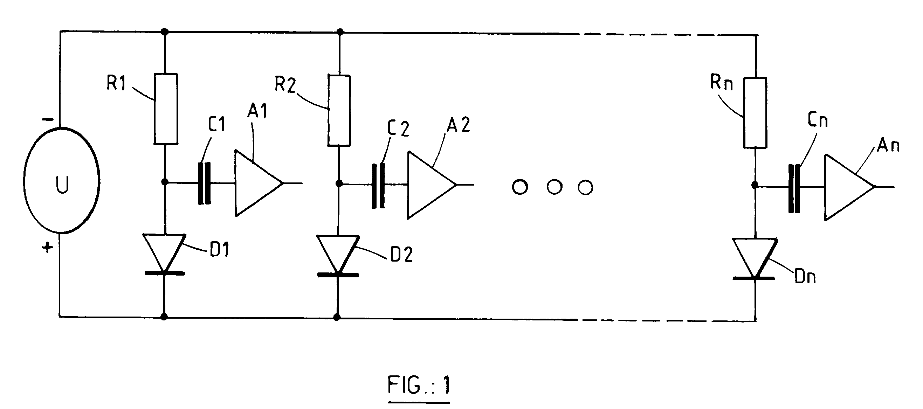

Pour faciliter la compréhension de l'invention, la figure 1 illustre un schéma équivalent d'un capteur de particules du type auquel s'applique l'invention. On voit qu'il comprend une pluralité de diodes D1, D2,.....Dn, dont chacune est montée en série avec un dispositif résistif tel qu'une résistance de polarisation R1, R2,.....Rn aux bornes d'une source commune de tension U. Chaque noeud entre une résistance et une diode est couplé, par l'intermédiaire d'un condensateur de couplage C1, C2,.....Cn, à un amplificateur A1, A2,.....An connecté à un circuit d'exploitation (non représenté). Un capteur peut comprendre jusqu'à mille diodes ménagées dans un même substrat semi-conducteur.

Le fonctionnement du capteur est basé sur la production, dans un substrat semi-conducteur maintenu en état d'appauvrissement total, de paires électron-trou à la suite d'impacts de particules sur le substrat. La formation de ces paires électron-trou donne naissance à un courant dans la diode qui est située à proximité du lieu d'impact de la particule. Ce courant peut être prélevé à la surface du substrat et après amplification être utilisé comme signal représentatif d'un impact local d'une particule.

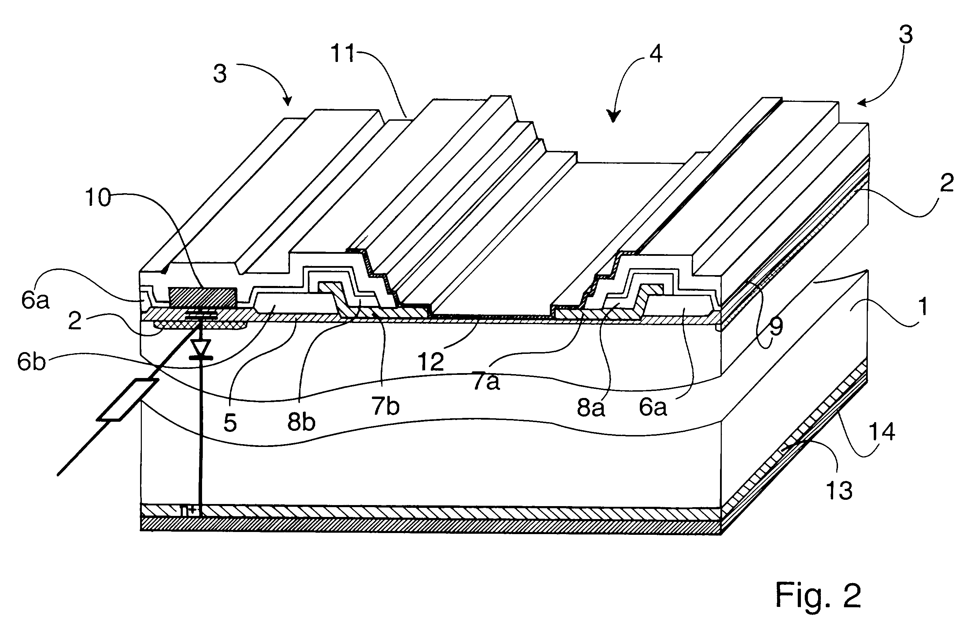

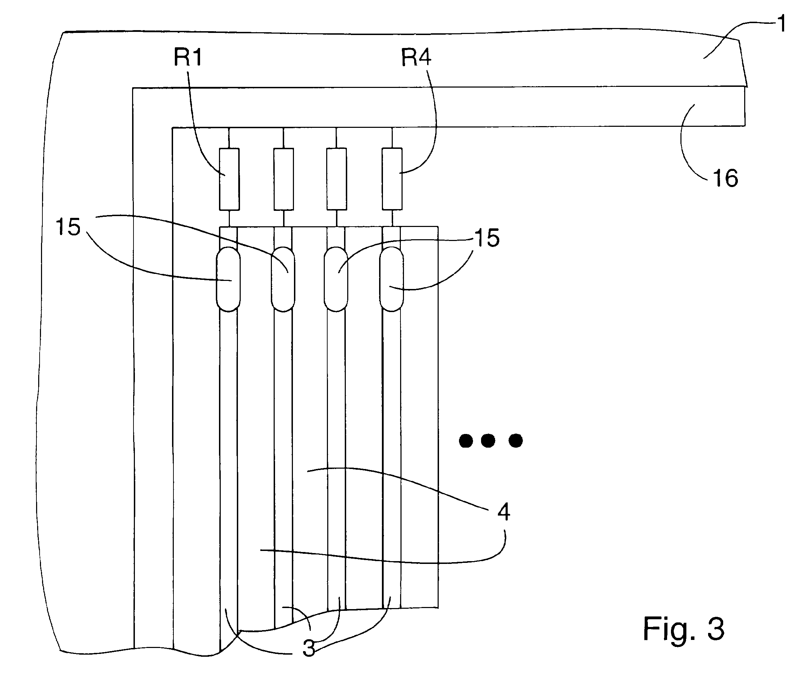

Les figures 2 et 3 montrent un mode de réalisation préféré d'un capteur selon l'invention.

Il comprend un substrat 1 semi-conducteur, de type n et en silicium par exemple.

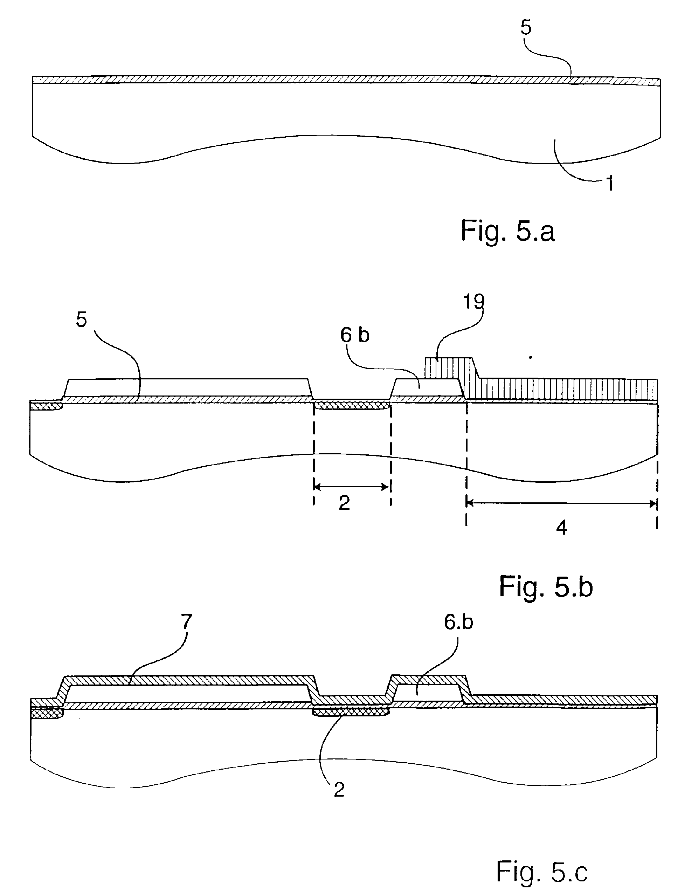

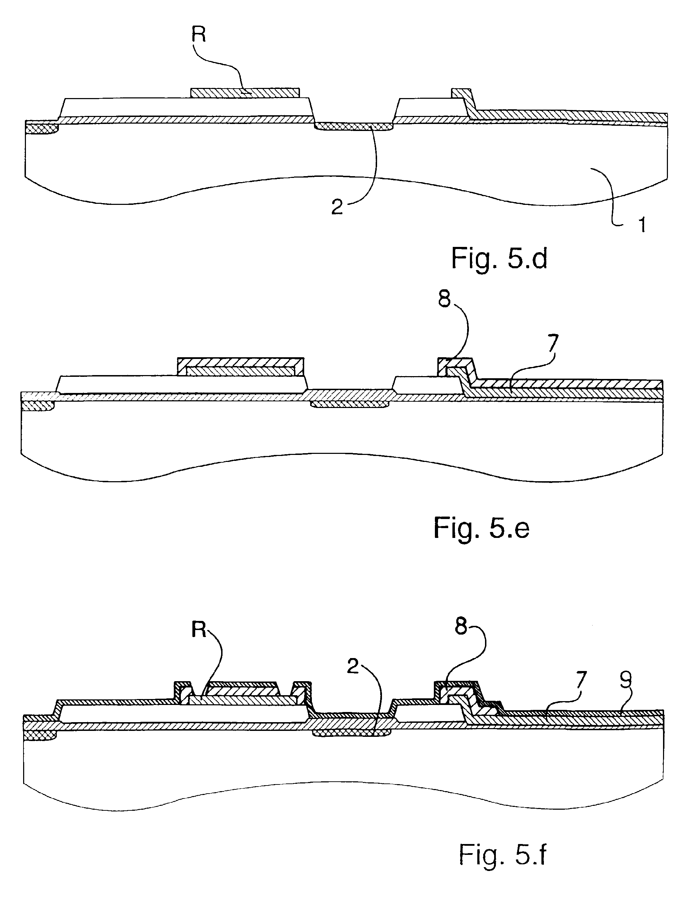

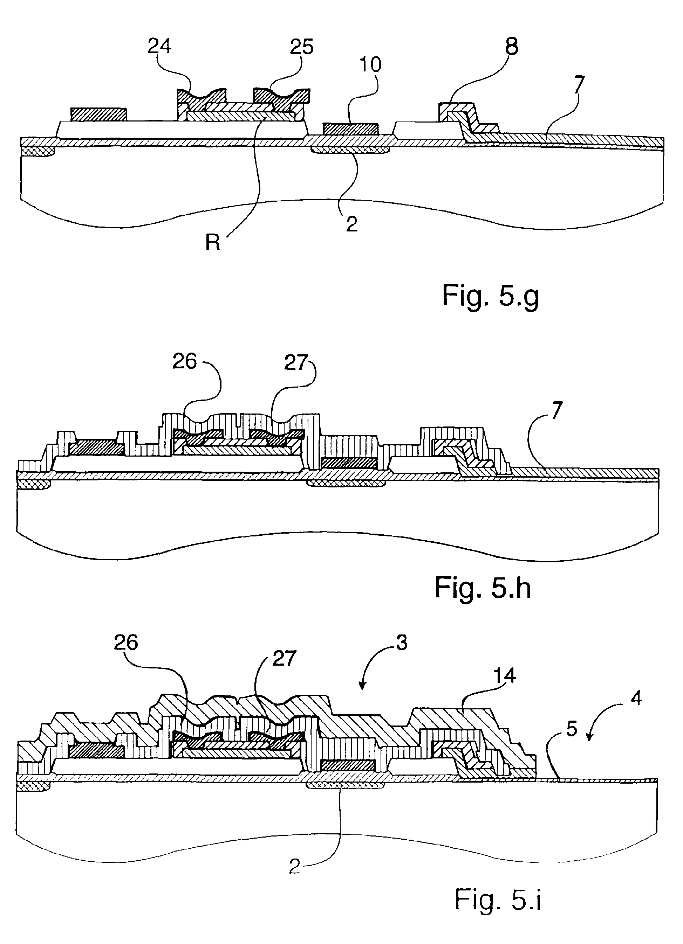

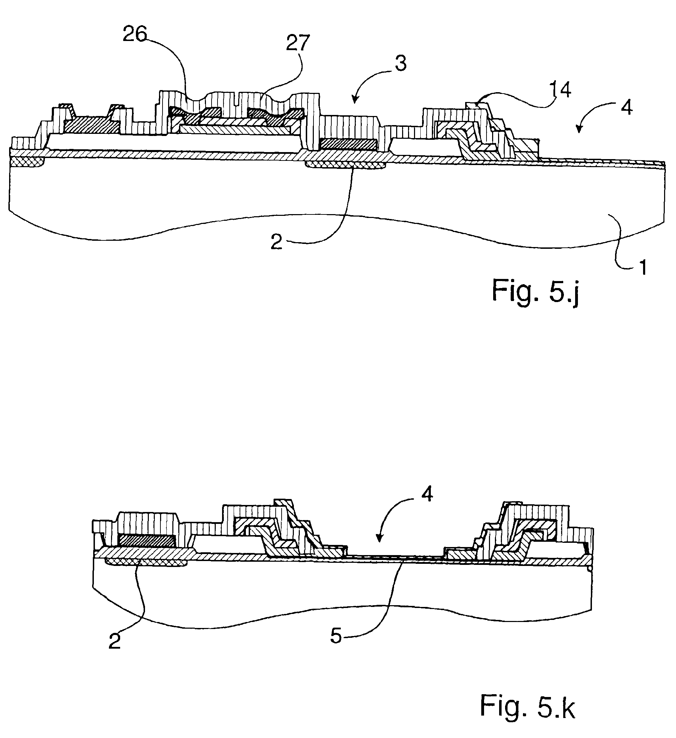

Dans ce substrat 1 est ménagée une pluralité de régions 2 dopées p⁺ formant chacune une diode à jonction avec le substrat. L'une des faces, ici la face supérieure, du substrat 1 est recouverte de plusieurs couches superposées en différents matériaux et dont les différentes configurations sont obtenues par des techniques de dépôt, de photolithographie et d'attaque connues des spécialistes. Elles sont désignées par des références numériques sans suffixe littéral sur la figure 5, les portions subsistant après la fabrication du capteur étant désignées sur les figures 2 et 3 par les références numériques correspondantes suivies le cas échéant de suffixes littéraux.

Ces différentes couches superposées définissent en association avec chaque diode D1 (ou région p⁺) une zone 3 de collecte de courant et une zone 4 de détection de particules, la zone 3 se superposant partiellement à la partie du substrat 1 dans laquelle est prévue la région p⁺ 2. La zone 4 est adjacente à la zone 3. La figure 2 montre par une vue en perspective partielle, une zone 3, une zone 4 et une partie seulement d'une autre zone 3 adjacente.

Une couche d'oxyde 5 recouvre entièrement la surface supérieure du substrat 1. Elle présente une épaisseur importante dans deux portions 6a et 6b situées dans chaque zone de collecte 3.

Cette couche d'oxyde 5 est recouverte partiellement d'une couche de polysilicium 7 dont il subsiste deux portions 7a et 7b en deux étages situées sur les flancs de la zone de collecte 3.

Une couche diélectrique ou d'une matière de couplage 8 forme deux portions distinctes 8a et 8b situées partiellement au-dessus des portions respectives 6a et 6b.

Une couche 9 de préférence en nitrure constitue une couche de protection.

Dans une région située au-dessus de la région de diode 2, la couche de diélectrique 8 est recouverte d'une plage métallique 10 (figure 5.g). Elle est destinée à former avec la région de diode 2, le condensateur de couplage, C1 à Cn.

Une couche de connexion 11 recouvre l'ensemble que l'on vient de décrire, à l'exception d'une partie extérieure des portions 7a et 7b de la couche de polysilicium 7. Cette couche assure la connexion avec l'amplificateur A1 à An correspondant.

La zone de détection 4 est délimitée entre ces dernières portions 7a et 7b où il subsiste la partie correspondante de la couche d'oxyde 5 ajustée à une épaisseur soigneusement choisie. Cette partie est recouverte d'une couche de métallisation 12 qui recouvre également une partie des flancs des deux zones de collecte 3 adjacentes.

On voit que les moyens qui définissent cette zone de détection 4 présentent une épaisseur qui n'est constituée que de la somme des épaisseurs des couches 5 et 12, valeur qui est nettement inférieure à l'épaisseur totale des zones 3 de collecte de courant. Cette valeur est suffisamment faible pour que toute particule de faible énergie, telle qu'une particule a ou un proton, puisse facilement pénétrer dans le substrat 1 et y créer les paires électron-trou escomptées, détectables par la zone de collecte adjacente.

Dans le mode de réalisation représenté aux figures 2 et 3, la face inférieure du substrat est recouverte d'une couche n⁺ 13, suivie d'une couche métallique 14 servant de connexion commune destinée à être reliée à la borne positive de la source de tension U (figure 1).

Par ailleurs, comme représenté plus particulièrement à la figure 3, les zones de collecte 3 et les zones de détection 4 matérialisent des bandes alternées juxtaposées s'étendant parallèlement à l'un des bords du substrat 1.

Les résistances R1 à Rn sont intégrées également dans ce dernier aux extrémités respectives des zones de collecte allongées 3. Celles-ci sont pourvues de plages de connexion 15 destinées à être reliées aux amplificateurs respectifs A1 à An.

Une piste de connexion 16 permet de relier toutes les résistances R1 à Rn à la borne négative de la source de tension U.

Le mode de réalisation que l'on vient de décrire à propos des figures 2 et 3 permet une localisation de particules de faible énergie selon une seule direction, à savoir celle qui s'étend perpendiculairement aux zones allongées 3 et 4. Une telle localisation unidirectionnelle peut être suffisante pour certaines expériences faites dans les détecteurs évoqués ci-dessus.

Selon une variante du capteur décrit, on peut également prévoir, comme connu en soi par l'article précité, sur la face du substrat 1 opposée aux zones de collecte et de détection 3 et 4, un dispositif de collecte de courant formé par un réseau de pistes conductrices parallèles orientées de façon croisée par rapport aux zones 3 et 4. Une localisation matricielle des particules incidentes devient alors possible.

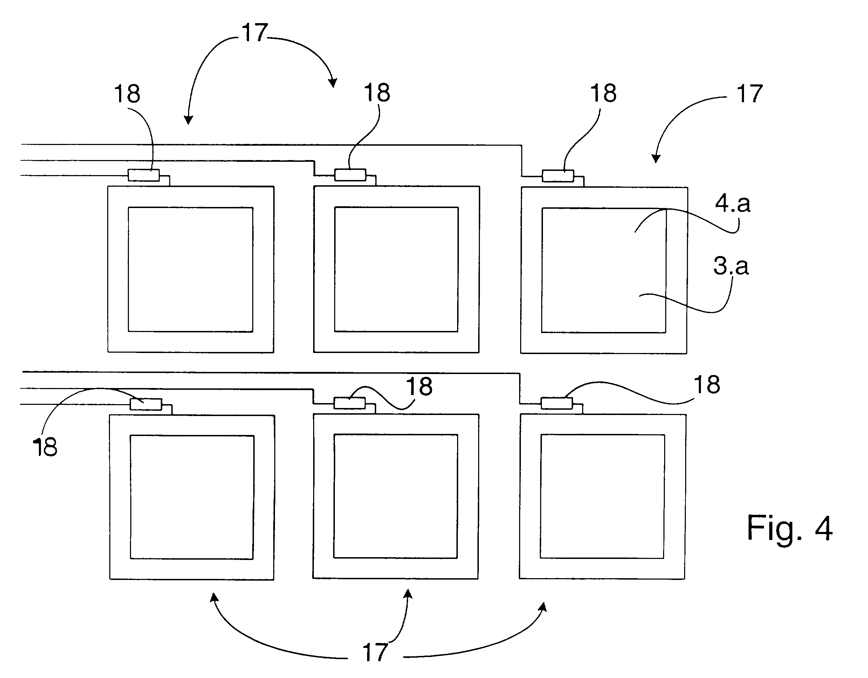

Selon le mode de réalisation de la figure 4, le capteur comprend un substrat (non dessiné) dans lequel sont ménagées des régions captrices 17 formées chacune d'une zone de détection 4A entourée d'une zone de collecte 3A. Celles-ci peuvent avoir la même structure de base que celle des zones 3 et 4 des figures 2 et 3 et comme elles sont disposées en matrice, une localisation des particules selon deux directions est ici également possible. Les zones de collecte 3A sont raccordées par des résistances 18 à la source de tension (non représentée).

Les variantes de capteur que l'on vient de décrire permettent la détection de particules de faible énergie grâce à la minceur et le faible nombre des couches prévues dans les zones 4 et 4A de détection des particules. Il est évident que des particules frappant le capteur dans les zones de collecte 3 ou 3A seront arrêtées par les couches de matière qui y sont superposées. La possibilité de détection des particules de faible énergie se fait donc au détriment d'une détection de l'ensemble du rayonnement de faible énergie frappant le capteur. Toutefois, la résolution n'est pas affectée et la solution proposée s'avère optimale pour de nombreuses applications.

La figure 5 montre schématiquement les étapes d'un procédé préféré de fabrication d'une autre variante d'un capteur selon l'invention. Il est à noter que les coupes de cette figure correspondent à une partie marginale légèrement différente du capteur représenté sur les figures 2 et 3 dans une région d'extrémité où se trouvent une résistance R1 à Rn et une plage de connexion 15 de la zone de collecte correspondante 4 à un amplificateur A1 à An.

Sur la figure 5.a, on voit qu'une couche d'oxyde 5 est d'abord déposée sur le substrat 1.

La figure 5.b montre plusieurs étapes de procédé. D'abord des ouvertures sont ménagées dans la couche d'oxyde 5 pour définir d'une part la région de diode 2 et d'autre part la largeur de la zone de détection 4. La dimension de la région de diode 2 est choisie en fonction de la capacité nécessaire du condensateur, C1 à Cn, respectivement.

Par ailleurs, si le capteur est réalisé selon la configuration en bandes de la figure 3, la largeur cumulée d'une zone de détection et d'une zone de collecte est de préférence de l'ordre de 50 µm et la largeur d'une zone de détection est égale ou supérieure à celle d'une zone de collecte et de préférence égale à 1, 5 fois la largeur de cette dernière.

Puis une couche de photorésist 19 est déposée pour permettre un dopage de la région de diode 2. Ce dopage est effectué de préférence au bore.

La couche de polysilicium 7 est ensuite déposée (figure 5.c). Elle est dopée et configurée convenablement pour donner naissance à la résistance (ici désignée par R) et aux portions 7a et 7b de la figure 2 (figure 5.d).

Puis, selon la figure 5.e, on dépose ou on fait croître la couche d'oxyde de couplage 8 suivie du dépôt de la couche de protection 9.

Une élimination sélective de ces couches 8 et 9 est ensuite effectuée (figure 5.f) pour ouvrir des contacts pour la résistance R, permettre le dépôt de la portion métallique 10 pour le condensateur de couplage et mettre à nu la couche 7 dans la zone de détection 4. Pour plus de clarté la couche 9 est omise dans les figures suivantes.

Selon la figure 5.g, du métal est sélectivement déposé pour former notamment les contacts 24 et 25 de la résistance R et la plage métallique 10.

La figure 5.h montre la réalisation de bornes de connexion 26 et 27, puis la figure 5.i l'attaque de la couche 7 puis de la couche d'oxyde 5 au droit de la zone de détection 4. Cette dernière opération permet d'ajuster l'épaisseur de la couche d'oxyde 5 dans cette zone à une valeur précise de 50 nm par exemple.

Enfin, le capteur est achevé par le dépôt de la couche de protection métallique 14 qui peut avoir une épaisseur de 40 nm par exemple, (figure 5.j). La figure 5.k montre une vue en coupe du capteur, en particulier, au niveau de la zone de détection 4.

## Revendications

1. Capteur de particules, notamment pour détecteur d'analyse des produits de collision engendrés dans une machine de physique des particules, comprenant
- un substrat semi-conducteur (1),
- une pluralité de régions (2) dopées ménagées dans une première surface dudit substrat (1) et formant chacune une diode à jonction (D1 à Dn) avec le substrat,
- des moyens pour définir au-dessus de ladite première face dudit substrat (1) une pluralité de zones de collecte de courant (3) pour collecter respectivement les courants circulant dans chacune desdites régions de diode (2) à la suite d'impacts de particules sur ledit capteur, lesdits moyens définissant les zones de collecte de courant étant destinés à être raccordés à des moyens d'exploitation des signaux formés par les courants collectés et
- des moyens de polarisation (U) pour polariser chacune desdites région de diode à jonction (2) et pour amener ledit substrat (1) dans un état complet d'appauvrissement,
- caractérisé en ce qu'il comprend également des moyens pour définir sur ladite première face du substrat une pluralité de zones de détection de particules (4) dont chacune est respectivement contiguë à une zone de collecte de courant (3), lesdits moyens définissant lesdites zones de détection ayant une épaisseur au-dessus dudit substrat (1) inférieure à celle desdits moyens définissant les zones de collecte de courant (3), de telle manière qu'ils permettent la détection de particules de faible énergie.

2. Capteur de particules suivant la revendication 1, caractérisé en ce que lesdites zones de collecte de courant (3) et lesdites zones de détection (4) présentent une forme allongée et sont disposées en alternance, parallèlement à un bord du substrat (1).

3. Capteur de particules suivant la revendication 1, caractérisé en ce que lesdites zones de collecte de courant (3A) entourent lesdites zones de détection (4A) en formant respectivement des plages (17) disposées en matrice sur ladite première face du substrat.

4. Capteur de particules suivant la revendication 2, caractérisé en ce que lesdits moyens définissant une zone de détection (4) comprennent une couche d'oxyde (5) déposée sur ladite première face du substrat (1).

5. Capteur de particules suivant la revendication 4, caractérisé en ce que ladite couche d'oxyde (5) est recouverte d'une mince couche protectrice de métallisation (12).

6. Capteur de particules suivant l'une quelconque des revendications 1 à 5, caractérisé en ce que la face dudit substrat (1) opposée à ladite première face comprend un dispositif de collecte de courant.

7. Capteur de particules suivant l'une quelconque des revendications 4 à 6, caractérisé en ce que l'épaisseur de ladite couche d'oxyde (5) est inférieure ou égale à 50 nm.

8. Capteur de particules suivant l'une quelconque des revendications 4 à 7, caractérisé en ce que l'épaisseur de ladite couche de protection (12) est inférieure ou égale à 40 nm.

9. Capteur de particules suivant la revendication 2, caractérisé en ce que la largeur d'une zone de détection de courant (4) est égale ou supérieure à celle d'une zone de collecte (3).
